# EUROPEAN PATENT SPECIFICATION

(11) **EP 3 104 182 B1**
(45) Date of publication and mention of the grant of the patent: **11.03.2020**
(21) Application number: 16173534.5
(22) Date of filing: 08.06.2016
(51) Int. Cl.: G01R 15/14, H03F 3/45, H05K 1/02, H03F 1/26, G01R 31/36, H02H 7/18, G01R 1/20

(54) **CURRENT DETECTING CIRCUIT**
STROMERKENNUNGSSCHALTUNG
CIRCUIT DE DÉTECTION DE COURANT

(30) Priority: 08.06.2015 KR 20150080860
(43) Date of publication of application: 14.12.2016
(73) Proprietor: Samsung SDI Co., Ltd., Giheung-gu Yongin-si, Gyeonggi-do 17084 (KR)
(72) Inventor: BAE, Jeong-Guk, Gyeonggi-do (KR); SUNDARAAMAN, KV, Gyeonggi-do (KR)
(74) Representative: Walaski, Jan Filip

(56) References cited:
- EP-A1- 2 244 319
- WO-A1-2007/028960
- WO-A2-2005/006392
- US-A- 5 438 252
- US-A- 5 945 853
- US-A1- 2003 025 514
- US-A1- 2013 307 511
- US-A1- 2015 077 091
- TIM REGAN ET AL: "Application Note 105: Current Sense Circuit Collection Making Sense Of Current", INTERNET CITATION, 1 December 2005 (2005-12-01), pages 1-118, XP002732091, Retrieved from the Internet: URL:http://cds.linear.com/docs/en/applicat ion-note/an105fa.pdf [retrieved on 2014-11-05]
- Stephen England: "High Side Resistive Shunt Current Sensing Using Current Shunt Monitors From Texas Instruments Table of Contents", , 4 April 2011 (2011-04-04), XP055303391, Retrieved from the Internet: URL:http://www.egr.msu.edu/classes/ece480/ capstone/spring11/group05/documents/app_no te_s11_dt5_stephen.pdf [retrieved on 2016-09-16]
- Unknown: "PCB Routing Guideline", , 17 November 2010 (2010-11-17), pages 802-812, XP055471431, United States DOI: 10.1086/605127 Retrieved from the Internet: URL:http://hrs.hiroseusa.com/FX10_PCB_rout ing_guideline_v1.2.pdf [retrieved on 2018-04-30]

## Description

The present invention relates to a current detecting circuit.

A shunt resistor may be arranged on a predetermined current path to measure a current.

In order to measure a minute current difference, a resistance value of the shunt resistor may be precisely manufactured. The resistance value of the shunt resistor is generally very low, and as a result, easily influenced by a resistance value generated according to a pattern of a connected wire. Therefore, how to design the pattern of the wire is an important consideration for designers.

Further, the current detecting circuit utilizing the shunt resistor may remove noise so as to measure a minute current change. The noise is largely divided into a common mode noise and a differential mode noise.

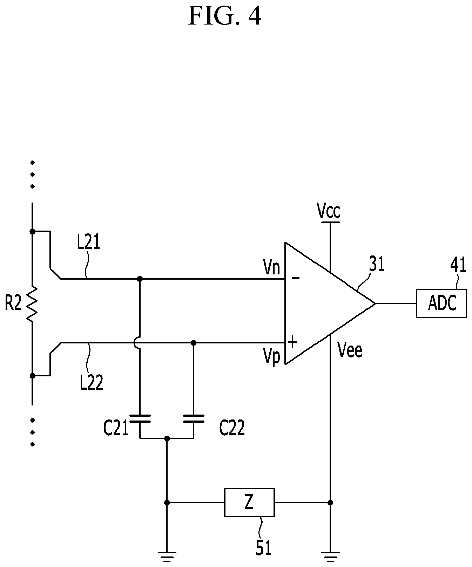

The common mode noise is noise having the same phase generated for ground terminals in two signal lines. In order to remove the common mode noise, there are various methods, but as one example, there is a method of connecting bypass capacitors C21 and C22 between the ground terminals and each of two signal lines L221 and L22 (see FIG. 4). The noise which is an AC component flows to the path through the bypass capacitors C21 and C22. The differential mode noise may be removed by setting a current path through the bypass capacitors C21 and C22.

However, referring to FIG. 4, an impedance 51 exists between the ground terminal connected with the bypass capacitors C21 and C22 and the ground terminal connected with a first power supply Vee of an amplifier 31. That is, the aforementioned two ground terminals are ground terminals that are physically different from each other to have a potential difference. Accordingly, a common mode current according to a potential difference flows, and it is difficult to detect an accurate current due to a noise component carried on the common mode current.

Further, because the position of the ground terminal connected with the bypass capacitors C21 and C22 is different from the position of the ground terminal connected to the first power supply Vee of the amplifier 31, different noise may be transferred.

EP 2244319 A1 relates to a battery module including an amplifying circuit and a detecting circuit.

US 2013/307511 A1 relates to a system and circuit for achieving bidirectional hysteretic current mode control of a converter.

US 2015/077091 A1 relates to an apparatus and method which make use of a single shunt and two or more instrumentation amplifiers, switchably measuring voltages at the shunt.

According to an aspect of the present invention, there is provided a current detecting circuit according to claim 1.

Accordingly, aspects of the present invention include a current detecting circuit having a new structure for solving the aforementioned problems.

Aspects of embodiments of the present invention relate to a current detecting circuit, and to a current detecting circuit including a shunt resistor.

Aspects of embodiments of the present invention include a current detecting circuit having advantages of improving current accuracy.

Further aspects of the present invention are set out in the dependent claims.

According to aspects of some embodiments of the present invention, it may be possible to provide a current detecting circuit with improved current accuracy.

Embodiments of the invention will now be described by way of example with reference to the accompanying drawings, in which:
FIG. 1 is a diagram illustrating a battery pack according to an example embodiment of the present invention.
FIG. 2 is a diagram illustrating a current detecting circuit according to the example embodiment of the present invention.
FIG. 3 is a diagram illustrating a part of the current detecting circuit implemented on a printed circuit board (PCB) according to the example embodiment of the present invention.
FIG. 4 is a diagram illustrating a current detecting circuit in the related art.

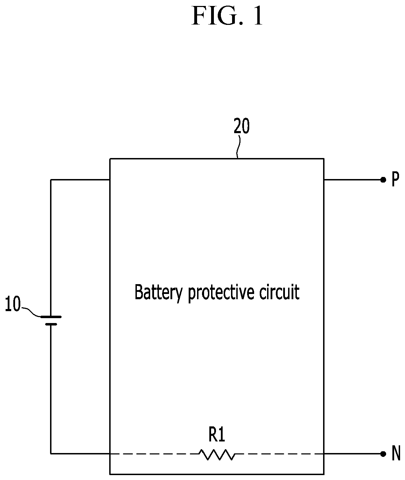

Referring to FIG. 1, a battery pack according to an example embodiment of the present invention includes a battery 10 and a battery protective circuit 20.

The battery protective circuit 20 is interposed between an anode and an external terminal P of the battery 10 and between a cathode and an external terminal N of the battery 10 to be positioned on a high current path.

The battery protective circuit 20 includes a charging field effect transistor and a discharging field effect transistor that are connected to each other in series to control charging and discharging according to control of a controller. The charging field effect transistor and the discharging field effect transistor may not operate well and, as a result, when overdischarging or overcharging occurs, the controller disconnects a fuse that is a secondary protective element to block the high current path. A protecting operation of the battery protective circuit 20 is an example embodiment, and the present invention is not limited thereto.

The battery protective circuit 20 of the present invention includes a shunt resistor R1 in order to perform a protection function of the battery 10. For example, in a charging mode, when the current flows to a discharging direction or a current over a predicted current flows, the current may be detected through the shunt resistor R1 and the battery protective circuit 20 may operate.

The shunt resistor R1 may be arranged at a position to measure a current change. The shunt resistor R1 may be positioned on the high current path of the battery protective circuit 20.

When the shunt resistor R1 is positioned on the high current path of the battery protective circuit 20, polarities of both voltages, i.e. the voltages at each terminal of the shunt resistor, may be changed according to a mode of the battery protective circuit 20. That is, a polarity of both voltages of the shunt resistor R1 when the battery protective circuit 20 is in the charging mode and a polarity of both voltages of the shunt resistor R1 when the battery protective circuit 20 is in the discharging mode are different from each other. The charging current in the charging mode and the discharging current in the discharging mode have different directions.

The charging current in the charging mode flows in order of the external terminal P, the battery protective circuit 20, the anode of the battery 10, the cathode of the battery 10, the battery protective circuit 20, and the external terminal N. The discharging current in the discharging mode flows in order of the external terminal N, the battery protective circuit 20, the cathode of the battery 10, the anode of the battery 10, the battery protective circuit 20, and the external terminal P.

An external device such as a load or a generator is connected to the external terminal P and the external terminal N.

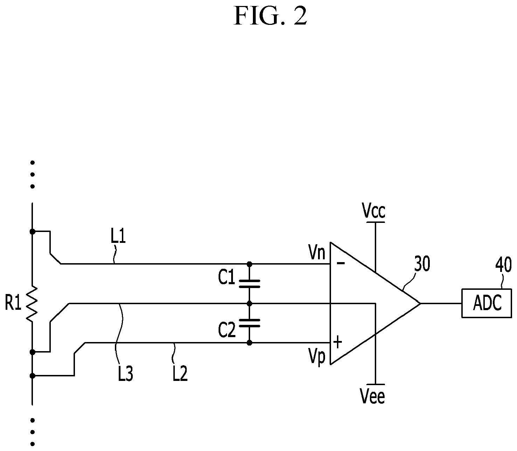

In FIG. 1, the shunt resistor R1 is positioned on the high current path between the cathode of the battery 10 and the external terminal N. As another example embodiment, the shunt resistor R1 may be positioned on the high current path between the anode of the battery 10 and the external terminal P. The position of the shunt resistor R1 may be determined by considering a voltage level that is applied to the first and second power supply terminals Vcc and Vee of the amplifier 30 of FIG. 2.

FIG. 2 is a diagram illustrating a current detecting circuit according to the example embodiment of the present invention.

Referring to FIG. 2, the current detecting circuit according to the example embodiment of the present invention includes the shunt resistor R1, first to third signal lines L1, L2, and L3, first and second capacitors C1 and C2, the amplifier 30, and an analog to digital converter (ADC) 40.

The first signal line L1 connects one terminal of the shunt resistor R1 and a first input terminal Vn of the amplifier 30 to each other. The second signal line L2 connects the other terminal of the shunt resistor R1 and a second input terminal Vp of the amplifier 30 to each other. The third signal line L3 connects the other terminal of the shunt resistor R1 and the first power supply terminal Vee of the amplifier 30 to each other. In this case, the first power supply terminal Vee may be a ground terminal of the amplifier 30.

Hereinafter, in the present invention, the "connecting" of two elements to each other means electrically connecting the two elements to each other as long as a function to be achieved is performed. The "electrically connecting" of the two elements to each other means that a passive element or an active element may be interposed therebetween. That is, because another element is interposed on a predetermined path of the current detecting circuit illustrated in FIG. 2, a person having ordinary skill in the art should recognize that certain modifications to the described embodiments may be made to have additional features or aspects, without departing from the scope of the present invention as defined by the claims.

The first capacitor C1 connects the first signal line L1 and the third signal line L3 to each other. The second capacitor C2 connects the second signal line L2 and the third signal line L3 to each other.

The first and second capacitors C1 and C2 as a bypass capacitor serve to reduce the common mode noise and the differential mode noise as described above.

As one example embodiment, a capacitance value of the first capacitor C1 and a capacitance value of the second capacitor C2 may be the same as or similar to each other. This is to match impedance of the pattern configured by each signal line with each other, and the capacitance values of the capacitors may be different from each other according to a detailed pattern.

The capacitance values of the first capacitor C1 and the second capacitor C2 may be determined according to a frequency value of the noise that is frequently applied in an environment where the current detecting circuit of the present invention is used. The first capacitor C1 and the second capacitor C2 serve to reduce the noise by bypassing an AC component of the noise. In this case, because the frequency value of the applied noise varies according to the environment where the current detecting circuit is used, the capacitance values of the first capacitor C1 and the second capacitor C2 are determined to efficiently remove the noise.

The amplifier 30 may be an operational amplifier (OP AMP). The amplifier 30 may be configured by a single power or double power OP AMP. Input and output terminals of the amplifier 30 may vary according to a product. It is described that the amplifier 30 in the present invention includes two input terminals Vn and Vp, two power supply terminals Vcc and Vee, and one out terminal.

The amplifier 30 amplifies and outputs a difference between the first voltage input to the first input terminal Vn and the second voltage input to the second input terminal Vp with a predetermined ratio. In the example embodiment, the first voltage is a voltage of one terminal of the shunt resistor Ri, and the second voltage is a voltage of the other terminal of the shunt resistor R1. The first input terminal Vn and the second input terminal Vp may be used to be replaced with each other.

The third signal line L3 connects the other terminal of the shunt resistor R1 and the first power supply terminal Vee of the amplifier 30 to each other through the same voltage node. Accordingly, one terminal of each of the first and second capacitors C1 and C2 and the first power supply terminal Vee are positioned on the same voltage node. As described above, the first power supply terminal Vee may be a ground terminal of the amplifier 30.

As described above, referring to FIG. 4, in a current protective circuit in the related art, the ground terminal of the bypass capacitors C21 and C22 and the ground terminal of the first power supply terminal Vee are different from each other to have a potential difference. Accordingly, there is a problem in that mismatch of the potentials is amplified in the amplifier, and as a result, an undesired signal may be amplified.

However, in the present invention, one terminal of each of the first and second capacitors C1 and C2 and the first power supply terminal Vee are positioned on physically the same voltage node, and as a result, the impedance 51 like FIG. 4 is not interposed therebetween. Accordingly, a cause of the common mode noise is removed to improve quality of the output signal.

The second power supply terminal Vcc of the amplifier 30 may be connected to a fixed voltage source. In this case, the voltage applied to the second power supply terminal Vcc may be larger than the voltage applied to the first power supply terminal Vee.

As another example embodiment, the second power supply terminal Vcc of the amplifier 30 may be connected to a node having a voltage level higher than that of the first power supply terminal Vee. A potential difference of the first power supply terminal Vee and the second power supply terminal Vcc may be determined by considering an output range of the amplifier 30.

An output of the amplifier 30 is input to the ADC 40, and the current detecting circuit of the present invention may measure the current flowing in the shunt resistor R1 according to an output of the ADC 40. The ADC 40 is a selective configuration, and the current detecting circuit further includes an analog circuit replacing the ADC 40 to measure the current.

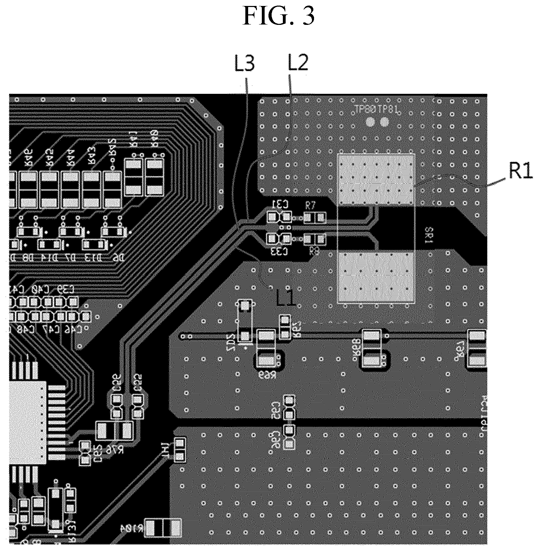

FIG. 3 is a diagram illustrating a part of the current detecting circuit implemented on a printed circuit board (PCB) according to the example embodiment of the present invention.

Referring to FIG. 3, the first to third signal lines L1, L2, and L3 may be patterned on the PCB.

The impedance of the first signal line L1 and the impedance of the second signal line L2 may be matched with each other. When the first signal line L1 and the second signal line L2 are configured by (or formed of) the same material (for example, copper), the patterns of the first signal line L1 and the second signal line L2 may be the same as or similar to each other. That is, because a length, a width, and a shape of the pattern of the first signal line L1 and a length, a width, and a shape of the pattern of the second signal line L2 are the same as or similar to each other, impedance matching may be implemented.

The third signal line L3 is patterned between the first and second signal lines L1 and L2. Accordingly, because a distance between the third signal line L3 and the first signal line L1 and a distance between the third signal line L3 and the second signal line L2 are the same as or similar to each other, impedance matching of the first and second signal lines L1 and L2 may be more easily obtained in some instances.

In this case, the pattern of the third signal line L3 is similarly configured to the pattern of the first or second signal line L1 or L2, and as a result, the impedance of the third signal line L3 may be matched with the impedance of the first or second signal line L1 or L2.

## Claims

1. A current detecting circuit, comprising:
a shunt resistor R1;
an amplifier (30);
a first signal line L1 connecting a first terminal of the shunt resistor to a first input terminal Vn of the amplifier;
a second signal line L2 connecting a second terminal of the shunt resistor to a second input terminal Vp of the amplifier; and
a third signal line L3 connecting the second terminal of the shunt resistor to a first power supply terminal Vee of the amplifier,
wherein the first power supply terminal is a ground terminal,
**characterised in that**:
a pattern of the third signal line is arranged between a pattern of the first signal line and a pattern of the second signal line, and
a distance between the third signal line L3 and the first signal line L1 and a distance between the third signal line L3 and the second signal line L2 are substantially the same.

2. The current detecting circuit of claim 1, further comprising:
a first capacitor C1 connecting the first signal line to the third signal line; and
a second capacitor C2 connecting the second signal line to the third signal line.

3. The current detecting circuit of any one of the preceding claims, wherein:
the length, the width and the shape of the first signal line and the second signal line are arranged such that an impedance of the first signal line is matched with an impedance of the second signal line.

4. The current detecting circuit of claim 3, wherein:
the length, the width and the shape of the third signal line are arranged such that an impedance of the third signal line is matched with the impedance of the first signal line and the impedance of the second signal line.

5. The current detecting circuit of any one of the claims 2 to 4 when dependent on claim 2, wherein:
the capacitance of the first capacitor and the capacitance of the second capacitor have the same value.

6. The current detecting circuit of any preceding claims, wherein:
a second power supply terminal Vcc of the amplifier is connected to a fixed voltage source; and
a voltage applied to the second power supply terminal is larger than a voltage applied to the first power supply terminal.

7. The current detecting circuit of any one of the preceding claims, wherein:
the shunt resistor is positioned on a high current path of a battery protective circuit.

8. The current detecting circuit of claim 7, wherein:
a polarity of both voltages of the shunt resistor when the battery protective circuit is in a charge mode is different from a polarity of the both voltages of the shunt resistor when the battery protective circuit is in a discharge mode.

9. The current detecting circuit of any preceding claims, wherein:
an output of the amplifier is arranged to be an input to an analog to digital converter ADC (40), and wherein the current detecting circuit is configured to measure a current flowing in the shunt resistor according to an output of the ADC.

## Patentansprüche

1. Stromerkennungsschaltung, umfassend:
einen Parallelwiderstand R₁;
einen Verstärker (30);
eine erste Signalleitung L₁, die einen ersten Anschluss des Parallelwiderstandes mit einem ersten Eingangsanschluss Vn des Verstärkers verbindet;
eine zweite Signalleitung L₂, die einen zweiten Anschluss des Parallelwiderstandes mit einem zweiten Eingangsanschluss Vp des Verstärkers verbindet; und
eine dritte Signalleitung L₃, die den zweiten Anschluss des Parallelwiderstandes mit einem ersten Stromversorgungsanschluss Vee des Verstärkers verbindet,
wobei der erste Stromversorgungsanschluss ein Erdanschluss ist,
**dadurch gekennzeichnet, dass**:
ein Muster der dritten Signalleitung zwischen einem Muster der ersten Signalleitung und einem Muster der zweiten Signalleitung angeordnet ist und
ein Abstand zwischen der dritten Signalleitung L₃ und der ersten Signalleitung L₁ und ein Abstand zwischen der dritten Signalleitung L₃ und der zweiten Signalleitung L₂ im Wesentlichen gleich sind.

2. Stromerkennungsschaltung nach Anspruch 1, ferner umfassend:
einen ersten Kondensator C₁, der die erste Signalleitung mit der dritten Signalleitung verbindet; und
einen zweiten Kondensator C₂, der die zweite Signalleitung mit der dritten Signalleitung verbindet.

3. Stromerkennungsschaltung nach einem der vorangehenden Ansprüche, wobei:
die Länge, die Breite und die Form der ersten Signalleitung und der zweiten Signalleitung derart angeordnet sind, dass sich eine Impedanz der ersten Signalleitung in Übereinstimmung mit einer Impedanz der zweiten Signalleitung befindet.

4. Stromerkennungsschaltung nach Anspruch 3, wobei:
die Länge, die Breite und die Form der dritten Signalleitung derart angeordnet sind, dass sich eine Impedanz der dritten Signalleitung in Übereinstimmung mit der Impedanz der ersten Signalleitung und der Impedanz der zweiten Signalleitung befindet.

5. Stromerkennungsschaltung nach einem der Ansprüche 2 bis 4, wenn abhängig von Anspruch 2, wobei:
die Kapazität des ersten Kondensators und die Kapazität des zweiten Kondensators den gleichen Wert aufweisen.

6. Stromerkennungsschaltung nach einem der vorangehenden Ansprüche, wobei:
ein zweiter Stromversorgungsanschluss Vcc des Verstärkers mit einer festen Spannungsquelle verbunden ist; und
eine an den zweiten Stromversorgungsanschluss angelegte Spannung größer ist als eine an den ersten Stromversorgungsanschluss angelegte Spannung.

7. Stromerkennungsschaltung nach einem der vorangehenden Ansprüche, wobei:
der Parallelwiderstand auf einem Hochstromweg einer Batterieschutzschaltung positioniert ist.

8. Stromerkennungsschaltung nach Anspruch 7, wobei:
eine Polarität beider Spannungen des Parallelwiderstandes, wenn sich die Batterieschutzschaltung in einem Lademodus befindet, sich unterscheidet von einer Polarität der beiden Spannungen des Parallelwiderstandes, wenn sich die Batterieschutzschaltung in einem Entlademodus befindet.

9. Stromerkennungsschaltung nach einem der vorangehenden Ansprüche, wobei:
ein Ausgang des Verstärkers so angeordnet ist, dass er ein Eingang zu einem Analog-Digital-Umsetzer ADC (40) ist, und wobei die Stromerkennungsschaltung so konfiguriert ist, dass sie einen in dem Parallelwiderstand fließenden Strom gemäß einem Ausgang des ADC misst.

## Revendications

1. Circuit de détection de courant, comprenant :
une résistance shunt R₁ ;
un amplificateur (30) ;
une première ligne de signal L₁ reliant une première borne de la résistance shunt à une première borne d'entrée Vn de l'amplificateur ;
une deuxième ligne de signal L₂ reliant une deuxième borne de la résistance shunt à une deuxième borne d'entrée Vp de l'amplificateur ; et
une troisième ligne de signal L₃ reliant la deuxième borne de la résistance shunt à une première borne d'alimentation électrique Vee de l'amplificateur,
dans lequel la première borne d'alimentation électrique est une borne de masse,
**caractérisé en ce que** :
un motif de la troisième ligne de signal est agencé entre un motif de la première ligne de signal et un motif de la deuxième ligne de signal, et
une distance entre la troisième ligne de signal L₃ et la première ligne de signal L₁ et une distance entre la troisième ligne de signal L₃ et la deuxième ligne de signal L₂ sont essentiellement identiques.

2. Circuit de détection de courant de la revendication 1, comprenant en outre :
un premier condensateur C₁ reliant la première ligne de signal à la troisième ligne de signal ; et
un deuxième condensateur C₂ reliant la deuxième ligne de signal à la troisième ligne de signal.

3. Circuit de détection de courant de l'une quelconque des revendications précédentes, dans lequel :
la longueur, la largeur et la forme de la première ligne de signal et de la deuxième ligne de signal sont conçues de sorte qu'une impédance de la première ligne de signal soit adaptée à une impédance de la deuxième ligne de signal.

4. Circuit de détection de courant de la revendication 3, dans lequel :
la longueur, la largeur et la forme de la troisième ligne de signal sont conçues de sorte qu'une impédance de la troisième ligne de signal soit adaptée à l'impédance de la première ligne de signal et à l'impédance de la deuxième ligne de signal.

5. Circuit de détection de courant de l'une quelconque des revendications 2 à 4, lorsqu'elle dépend de la revendication 2, dans lequel :
la capacité du premier condensateur et la capacité du deuxième condensateur ont la même valeur.

6. Circuit de détection de courant de l'une des revendications précédentes, dans lequel :
une deuxième borne d'alimentation électrique Vcc de l'amplificateur est reliée à une source de tension fixe ; et
une tension appliquée à la deuxième borne d'alimentation électrique est supérieure à une tension appliquée à la première borne d'alimentation électrique.

7. Circuit de détection de courant de l'une quelconque des revendications précédentes, dans lequel :
la résistance shunt est positionnée sur un trajet de courant élevé d'un circuit de protection de batterie.

8. Circuit de détection de courant de la revendication 7, dans lequel :
une polarité des deux tensions de la résistance shunt lorsque le circuit de protection de batterie est en mode de charge est différente d'une polarité des deux tensions de la résistance shunt lorsque le circuit de protection de batterie est en mode de décharge.

9. Circuit de détection de courant de l'une des revendications précédentes, dans lequel :
une sortie de l'amplificateur est conçue pour être une entrée à un convertisseur analogique-numérique ADC (40), et où le circuit de détection de courant est configuré pour mesurer un courant circulant dans la résistance shunt en fonction d'une sortie de l'ADC.
